# EUROPEAN PATENT SPECIFICATION

(11) **EP 3 797 925 B1**
(45) Date of publication and mention of the grant of the patent: **25.03.2026**
(21) Application number: 20191860.4
(22) Date of filing: 20.08.2020
(51) Int. Cl.: B23Q 11/00, B23Q 11/08, H05K 3/22, B23Q 1/70

(54) **ROUTING APPARATUS**
ROUTINGVORRICHTUNG
APPAREIL DE ROUTAGE

(30) Priority: 26.09.2019 KR 20190119042
(43) Date of publication of application: 31.03.2021
(73) Proprietor: MSTECH Co., Ltd, Manan-gu Anyang-si, Gyeonggi-do, 14098 (KR)
(72) Inventor: CHOI, Moosong, Seongnam-si, Gyeonggi-do (KR)
(74) Representative: M. Zardi & Co S.A.

(56) References cited:
- KR-B1- 100 730 780
- KR-Y1- 200 176 647
- US-A- 4 909 681

## Description

### BACKGROUND OF THE INVENTION

### 1. Field of the Invention

The present invention relates to a routing apparatus, and more particularly, to a routing apparatus in which dispersion of dust is minimized in a first mode and bodies in other forms are simply combined to collect dust in a second mode, wherein in the first mode, a routing bit cuts a bridge of a board by using a detachable body and in the second mode, dust is collected and dust of a jig table is also removed.

### 2. Description of the Related Art

In general, printed circuit boards (PCB) are widely used in various kinds of industrial facilities such as household products including TV sets and cameras and computers. Such PCBs are mass-produced in such a way that a plurality of unit boards is arranged on one board (board array) at regular intervals and is separated into one unit board from the board to be assembled to electronic products. Here, in order to separate into one unit board from the board, a routing apparatus is used. Accordingly, each unit board is cut from the board, where the plurality of unit boards is arranged, by using the routing apparatus.

The routing apparatus includes a jig table, a routing bit, and a spindle motor, wherein the jig table fixes the PCB, the routing bit is used to separate a unit board from the board, and the spindle motor is used to rotates the routing bit at high speed. A routing operation is performed in such a way that a bridge of the board is cut by using the routing bit which rotates at high speed while the board is fixed on the jig table.

In a general routing operation, the board is cut by the routing bit rotating at high speed and thus, dust is greatly generated. Therefore, most routing apparatuses include a dust collector for disposing of dust generated during a routing operation.

For example, Korean Patent No. 10-0945391 discloses a router including a dust collecting module for collecting cutting chips generated at a work stage. However, such a router collects dust by using a collecting duct having a size similar to the board at a lower part of a bit which cuts the board. Accordingly, power of collecting dust is reduced at the edge of an inlet of the collecting duct and thereby, dust collection efficiency is decreased.

Korean Document KR 200 176 647 Y1 discloses a routing apparatus on which the preamble appended claim 1 is based, said apparatus comprising a base body with a routing bit, and a first body.

### SUMMARY OF THE INVENTION

The present invention provides a routing apparatus according to appended claim 1.
Dispersion of dust is minimized in a first mode and bodies in other forms are simply combined to collect dust in a second mode, wherein in the first mode, a routing bit cuts a bridge of a board by using a detachable body and in the second mode, dust is collected and dust of a jig table is also removed.

The routing apparatus cuts a bridge of a board placed on a jig table and separates the board into a unit board, the routing apparatus including: a base body including a routing bit combined thereto in a downward direction for cutting the bridge on a first space located within the base body and moving in horizontal and vertical directions; a first body including a second space connected to the first space of the base body, combining to the base body to be detachable by surrounding the routing bit so that the routing bit is placed in the second space, and including a first brush at the end part thereof toward the board; and an absorbing unit absorbing the first space of the base body, wherein in a first mode, where the routing bit cuts the bridge, the first body is combined to the base body, the base body moves in a vertical direction, and the absorbing unit absorbs air and dust from the second space of the first body through the first space of the base body while the first brush contacts the board.

The routing apparatus further includes a second body which includes a third space connected to the first space of the base body, is combined to the base body to be detachable, and includes a second brush at the end part thereof toward the board, wherein in a second mode, where dust of the jig table is removed, the second body is combined to the base body, the base body moves in a vertical direction, and the absorbing unit absorbs air and dust from the third space of the second body through the first space of the base body while the second brush contacts the jig table.

The second body is longer than the first body in a vertical direction and the end part of the second body is projected further toward a downward direction than the end part of the routing bit, when the second body is combined to the base body.

The routing apparatus may further include a storage unit in which a first storage groove storing the first body and a second storage groove storing the second body are formed, wherein in the first mode, the base body may move to the storage unit and may be combined to the first body by using a magnetic force and in the second mode, the base body may move to the storage unit and may be combined to the second body by using a magnetic force.

The storage unit may include: a cover for opening the whole or a part of the upper part of the first storage groove or opening the whole or a part of the upper part of the second storage groove while moving in a horizontal direction on the upper part of the storage unit; and a cover operating unit for moving the cover in a horizontal direction, wherein when the base body is to be combined to the first body, the cover operating unit may move the cover to open the whole of the upper part of the first storage groove, and when the first body combined to the base body is to be separated, the cover operating unit may move the cover to partially open the upper part of the first storage groove while the first body is moved to the first storage groove, and wherein when the base body is to be combined to the second body, the cover operating unit may move the cover to open the whole of the upper part of the second storage groove, and when the second body combined to the base body is to be separated, the cover operating unit may move the cover to partially open the upper part of the second storage groove while the second body is moved to the second storage groove.

The routing apparatus may further include: a plurality of fixing pins combined to be detachable on the upper surface of the jig table; and a gripper combined to the base body for moving the fixing pins to the upper surface of the jig table from a pin storage unit or moving the fixing pins combined to the upper surface of the jig table to the pin storage unit, wherein the board may be fixed by the fixing pins combined to the jig table.

The fixing pin may be fixed on the jig table by using a magnetic force and the gripper may remove the fixing pin from the jig table by using power greater than the magnetic force used to combine the fixing pin to the jig table.

The fixing pin may include: a lower body in which the bottom surface thereof contacts and is combined to the jig table; and an upper body having a cylindrical form combined to the upper part of the lower body, including a projection formed along an outer circumference surface thereof, and including a stepped part, where the board is combined and fixed, at the upper part of the projection, wherein the gripper may include a combination groove at a part gripping the fixing pin, the lower part of the combination groove may contact the lower part of the projection in the upper body, and the combination groove may grip and move the fixing pin since the projection of the fixing pin is combined to the combination groove.

### BRIEF DESCRIPTION OF THE DRAWINGS

The above and other features and advantages of the present invention will become more apparent by describing in detail exemplary embodiments thereof with reference to the attached drawings in which:
FIG. 1 is a perspective view of a routing apparatus according to an embodiment of the present invention;
FIG. 2 illustrates a board placed on a jig table of the routing apparatus of FIG. 1;
FIG. 3 is a view for explaining operations of absorbing dusts in the routing apparatus of FIG. 1;
FIGS. 4A and 4B illustrate a first body and a second body both combined to a base body illustrated in FIG. 3;
FIG. 5 is a cross-sectional view illustrating that a second body is combined to a base body of FIG. 3;
FIG. 6 is an enlarged view illustrating that a second body is combined to a base body in FIG. 5;
FIG. 7 is an enlarged view of a cross-section illustrating that a first body is combined to a base body of FIG. 3;
FIG. 8 illustrates a storage unit of the routing apparatus of FIG. 1;
FIG. 9 illustrates a gripper combined to a base body of FIG. 3; and
FIG. 10 illustrates a fixing pin combined to a jig table in the routing apparatus of FIG. 1.

### DETAILED DESCRIPTION OF THE INVENTION

The exemplary embodiments of the present invention will be described in detail with reference to the accompanying drawings and description of the drawings so as to fully understand advantages and objectives of the present invention.

Hereinafter, embodiments of the present invention will be described more fully with reference to the accompanying drawings. In the drawings, like reference numerals denote like elements.

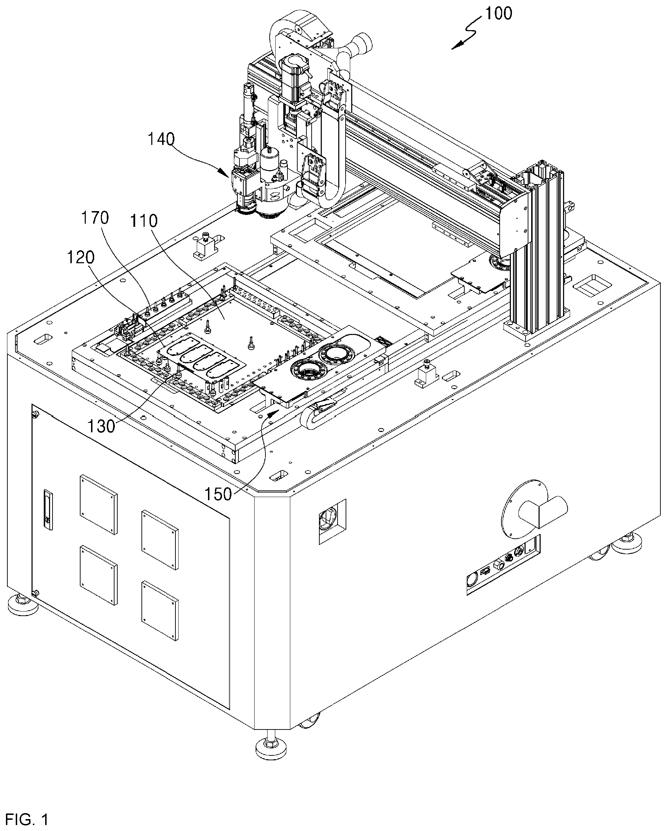

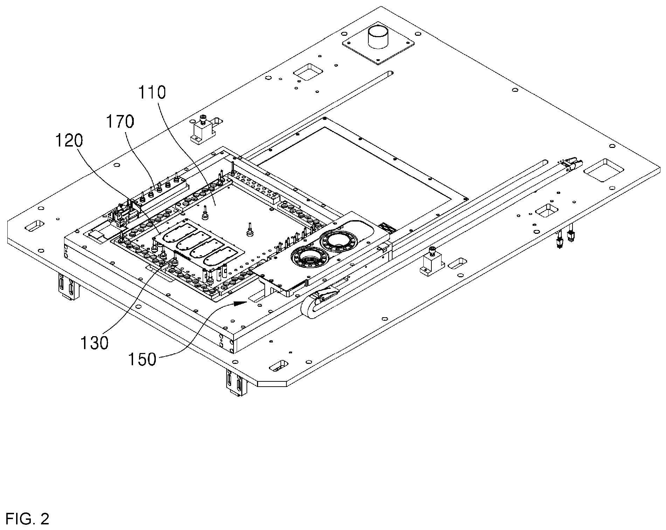

FIG. 1 is a perspective view of a routing apparatus 100 according to an embodiment of the present invention and FIG. 2 illustrates a board 120 placed on a jig table 110 of the routing apparatus 100 of FIG. 1.

Referring to FIGS. 1 and 2, the routing apparatus 100 cuts the board 120 placed on the jig table 110 into a unit board by using a routing bit. The jig table 110 includes a fixing pin 130 combined thereto and the edge of the board 120 is combined to the upper part of the fixing pin 130 to fix the board 120. As such, since the board 120 is spaced apart from and fixed to the upper part of the jig table 110, it is hard to completely collect dust even if dust is collected from the upper part while the unit board is cut by using the routing bit. Accordingly, the routing apparatus according to the present invention which will be described below collects dust by using a method having high dust collection efficiency, while the routing bit cuts unit boards, and also collects dust fell on the jig table 110. However, in the present invention, the board 120 may not be always combined to the fixing pin 130 on the jig table 110 and may be spaced apart from and fixed to the upper part of the jig table 110 by using another method.

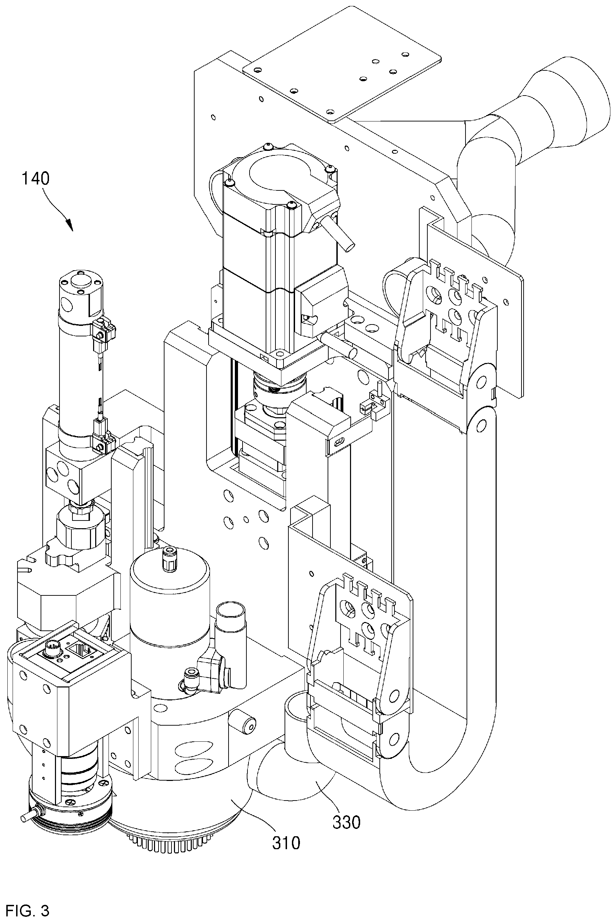

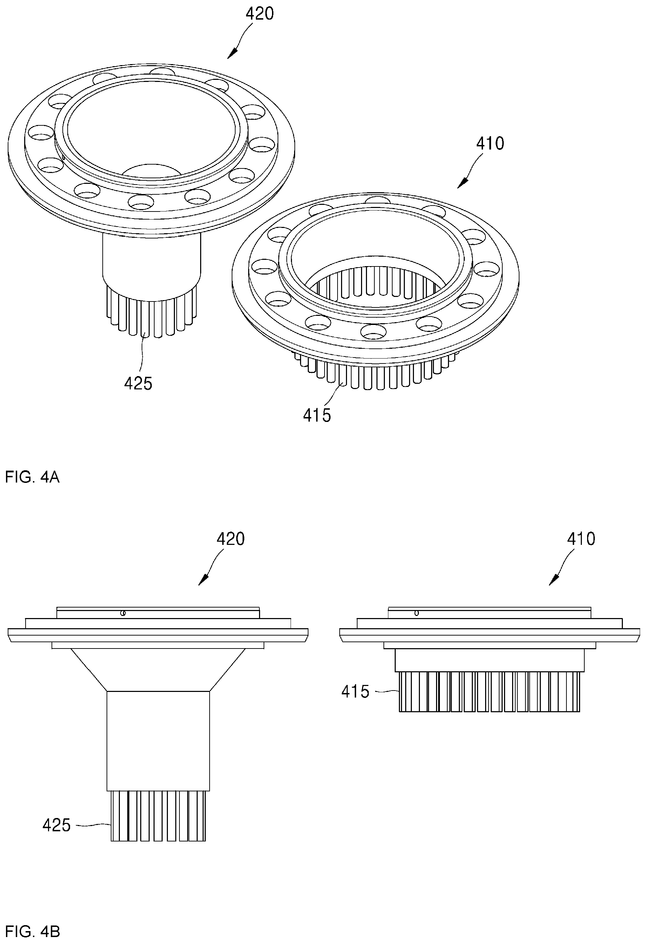

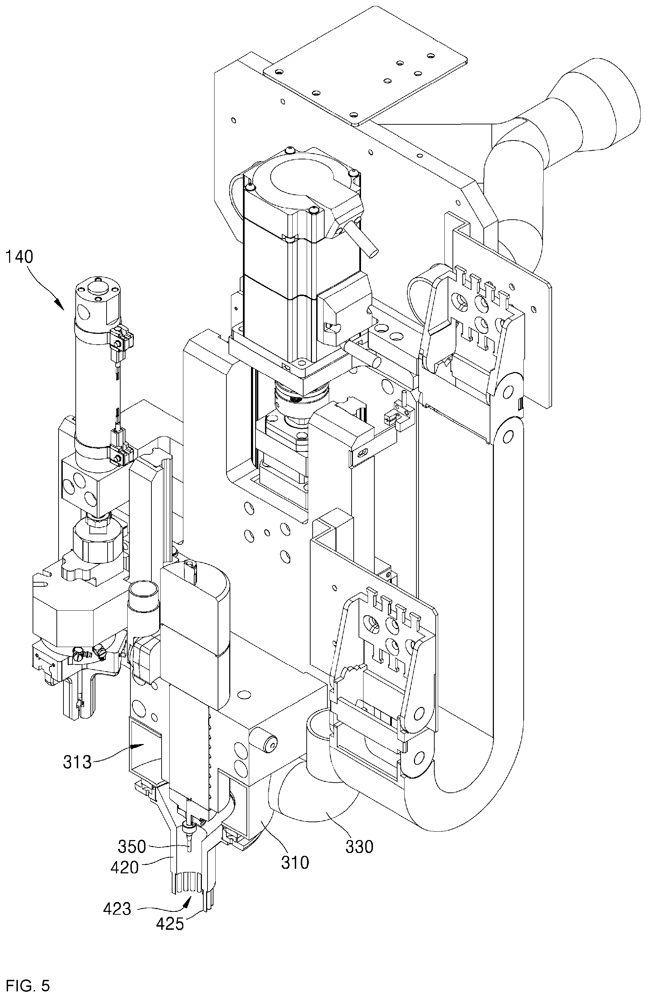

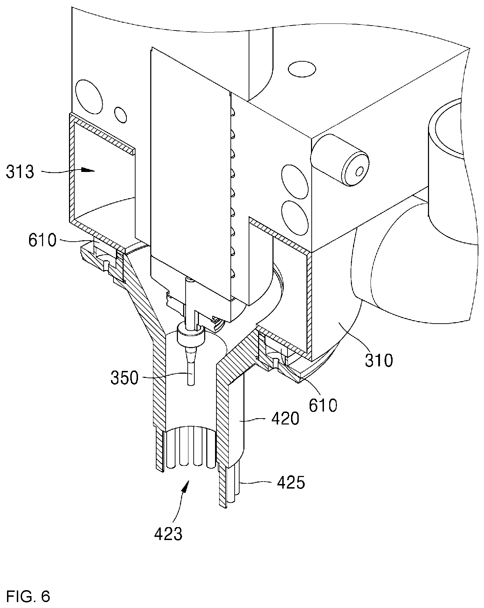

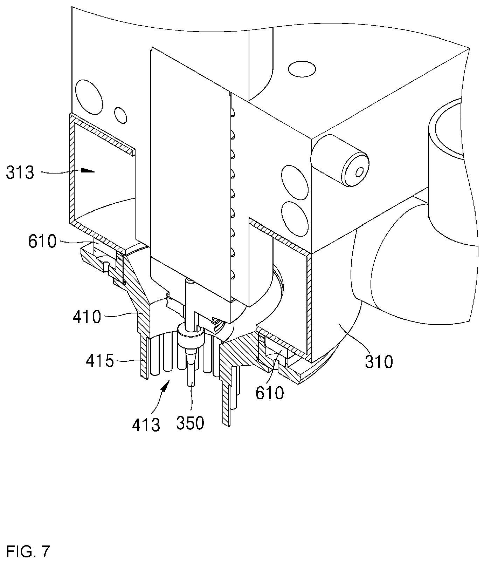

FIG. 3 is a view for explaining operations of absorbing dusts in the routing apparatus 100 of FIG. 1, FIGS. 4A and 4B illustrate a first body 410 and a second body 420 both combined to a base body 310 illustrated in FIG. 3, FIG. 5 is a cross-sectional view illustrating that the second body 420 is combined to the base body 310 of FIG. 3, FIG. 6 is an enlarged view illustrating that the second body 420 is combined to the base body 310 in FIG. 5, and FIG. 7 is an enlarged view of a cross-section illustrating that the first body 410 is combined to the base body 310 of FIG. 3.

Referring to FIGS. 1 through 7, the routing apparatus 100 includes the base body 310, the first body 410, the second body 420, and an absorbing unit 330.

The base body 310 includes a routing bit 350 combined thereto in a downward direction for cutting a bridge of the board 120 on a first space 313 located within the base body 310 and moves in horizontal and vertical directions. That is, the base body 310 includes the first space 313, which is empty, and the routing bit 350 is combined in the first space 313. The routing bit 350 is projected further toward a downward direction than the lower end part of the base body 310 and thereby, contacts the bridge of the board 120 to cut the bridge. While the base body 310 moves in horizontal and vertical direction and moves along the bridge to be cut, the base body 310 cuts the board 120 by using the routing bit 350. A moving path of the base body 310 may be controlled by a controller (not illustrated), wherein the controller may be a computer or a microprocessor. Cutting the bridge of the board 120 by using the routing bit 350 may be a general method of a routing apparatus and thus, detailed description is omitted hereinafter.

The absorbing unit 330 is connected to the first space 313 of the base body 310 and absorbs the first space 313 so as to absorb dust. The absorbing unit 330 delivers the absorbed dust to a collecting unit (not illustrated). In the drawing, the structure of the absorbing unit 330 is not accurately illustrated, however, the absorbing unit 330 may have various structures or shapes if it may absorb air from the first space 313 of the base body 310.

The base body 310 includes the first body 410 or the second body 420 combined thereto. Firstly, the case where the first body 410 is combined to the base body 310 is described with reference to FIG. 7. The first body 410 includes a second space 413, which is empty. When the first body 410 is combined to the base body 310, the second space 413 is connected to the first space 313 to form one continuous space. Also, the routing bit 350 is placed in the second space 413 of the first body 410. That is, the first body 410 has a shape for surrounding the routing bit 350 so that the routing bit 350 is placed in the second space 413 which is empty in the first body 410. In the drawing, the first body 410 has a cylindrical form. However, the present invention is not limited thereto and the first body 410 may have other various forms. The first body 410 is combined to the base body 310 to be detachable. For example, the lower end part of the base body 310 or the upper end part of the first body 410 may have a magnetic force to be combined to each other. Also, as illustrated in FIG. 7, a magnetic material 610 having a magnetic force may be combined to a position where the base body 310 and the first body 410 are combined so that the base body 310 and the first body 410 is combined to be detachable.

A first brush 415 is formed at the lower end part of the first body 410 toward the board 120. In a first mode, where the routing bit 350 cuts the bridge of the board 120, the base body 310 moves in a vertical direction and the first brush 415 contacts the board 120 so that dust generated while cutting the board 120 may not be released to the outside. The end part of the routing bit 350 may be or may not be projected further toward a downward direction than the lower end part of the first brush 415. That is, since the first brush 415 is smoothly spread while contacting the board 120, the first brush 415 only needs to contact the board 120 to seal surroundings of the routing bit 350 when the routing bit 350 is placed at a position to cut the bridge of the board 120. As described above, while the first brush 415 contacts the board 120 and seals surroundings of the routing bit 350, the routing bit 350 cuts the bridge of the board 120 and the absorbing unit 330 operates in the first mode. Accordingly, dust and air from the second space 413 of the first body 410 move to the absorbing unit 330 through the first space 313 of the base body 310.

Next, a case when the second body 420 is combined to the base body 310 will be described below with reference to FIGS. 5 and 6. The second body 420 includes a third space 423, which is empty. When the second body 420 is combined to the base body 310, the third space 423 is connected to the first space 313 to form one continuous space. Also, the routing bit 350 is placed in the third space 423 of the second body 420. That is, the second body 420 has a shape for surrounding the routing bit 350 so that the routing bit 350 is placed in the third space 423 which is empty in the second body 420. In addition, while the routing bit 350 is removed from the base body 310, the second body 420 is combined to the base body 310. In the drawing, the second body 420 has a cylindrical form. However, the present invention is not limited thereto and the second body 420 may have other various forms. The second body 420 is combined to the base body 310 to be detachable. For example, the lower end part of the base body 310 or the upper end part of the second body 420 may have a magnetic force to be combined to each other. Also, as illustrated in FIG. 6, the magnetic material 610 having a magnetic force may be combined to a position where the base body 310 and the second body 420 are combined so that the base body 310 and the second body 420 may be combined to be detachable.

A second brush 425 is formed at the lower end part of the second body 420 toward the board 120. In a second mode, where dust of the jig table 110 is removed, the base body 310 moves in a vertical direction and the second brush 425 contacts the jig table 110 so that dust of the jig table 110 may be absorbed while the jig table 110 is not damaged. When the second body 420 is combined to the base body 310 while the routing bit 350 is combined to the base body 310, the end part of the second body 420 combined to the base body 310 may be projected further toward a downward direction than the end part of the routing bit 350. That is, the second brush 425 is smoothly spread while contacting the jig table 110 and here, the end part of the second body 420 needs to be projected further toward a downward direction than the end part of the routing bit 350 so that the routing bit 350 may not contact the jig table 110. Accordingly, the second body 420 needs to be longer than the first body 410 in a vertical direction. Since the absorbing unit 330 operates while the second brush 425 contacts the jig table 110 in the second mode, dust and air from the jig table 110 placed in the third space 423 of the second body 420 move to the absorbing unit 330 through the first space 313 of the base body 310.

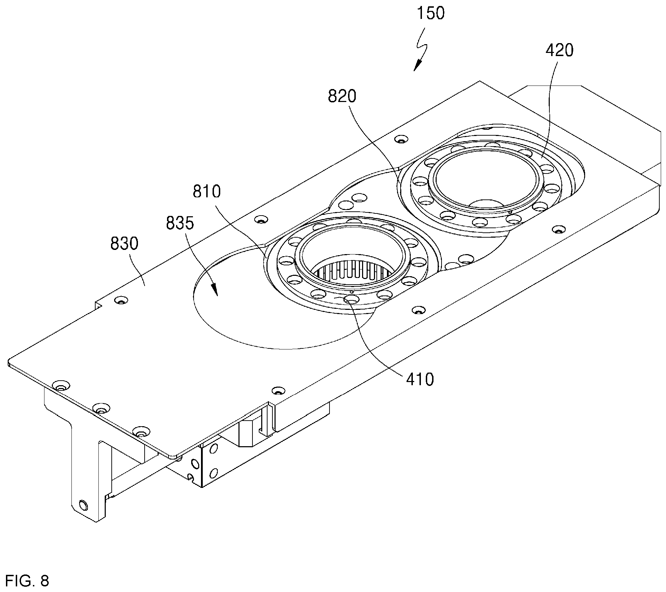

FIG. 8 illustrates a storage unit 150 of the routing apparatus 100 of FIG. 1.

Referring to FIGS. 1 through 8, the routing apparatus 100 may further include the storage unit 150 in which a first storage groove 810 storing the first body 410 and a second storage groove 820 storing the second body 420 are formed. That is, in the first mode, the base body 310 moves to the first storage groove 810 in the storage unit 150 and is combined to the first body 410 by using a magnetic force. In the second mode, the base body 310 moves to the second storage groove 820 in the storage unit 150 and is combined to the second body 420 by using a magnetic force.

In this case, since the second body 420 cannot be directly combined to the base body 310 while the first body 410 is combined to the base body 310, the storage unit 150 may further include a cover 830 and a cover operating unit (not illustrated). The cover 830 may open the whole or a part of the upper part of the first storage groove 810 or may open the whole or a part of the upper part of the second storage groove 820 while moving in a horizontal direction on the upper part of the storage unit 150. Also, the cover operating unit may move the cover 830 in a horizontal direction. For example, the cover 830 may include a first penetration hole, a second penetration hole, and a third penetration hole, wherein the first penetration hole has the same size as the first storage groove 810, the second penetration hole has the same size as the second storage groove 820, and the third penetration hole may partially open the first storage groove 810 or the second storage groove 820. In FIG. 8, the first penetration hole through the third penetration hole are connected to each other. However, the present invention is not limited thereto and the cover 830 may have other various forms if the cover 830 may function as described below.

When the base body 310 is to be combined to the first body 410, the cover operating unit moves the cover 830 to open the whole of the upper part of the first storage groove 810. Here, the base body 310 moves to the upper part of the first body 410 and may be combined to the first body 410 by using a magnetic force. For example, in this case, the cover operating unit may move the cover 830 in a horizontal direction so that the first penetration hole of the cover 830 is placed on the upper part of the first storage groove 810.

When the first body 410 combined to the base body 310 is to be separated, the cover operating unit moves the cover 830 to partially open the upper part of the first storage groove 810 while the first body 410 is moved to the first storage groove 810. Here, the base body 310 is moved and the first body 410 is caught in the cover 830 to be stored in the first storage groove 810. Accordingly, the first body 410 and the base body 310 may be separated from each other. For example, in this case, the cover operating unit may move the cover 830 in a horizontal direction so that the third penetration hole of the cover 830 is placed on the upper part of the first storage groove 810. FIG. 8 illustrates such state.

Combination and separation between the base body 310 and the second body 420 may be performed as described above. That is, when the base body 310 is to be combined to the second body 420, the cover operating unit moves the cover 830 to open the whole of the upper part of the second storage groove 820. Here, the base body 310 moves to the upper part of the second body 420 and may be combined to the second body 420 by using a magnetic force. For example, in this case, the cover operating unit may move the cover 830 in a horizontal direction so that the second penetration hole of the cover 830 is placed on the upper part of the second storage groove 820.

When the second body 420 combined to the base body 310 is to be separated, the cover operating unit moves the cover 830 to partially open the upper part of the second storage groove 820 while the second body 420 is moved to the second storage groove 820. Here, the base body 310 is moved and the second body 420 is caught in the cover 830 to be stored in the second storage groove 820. Accordingly, the second body 420 and the base body 310 may be separated from each other. For example, in this case, the cover operating unit may move the cover 830 in a horizontal direction so that the third penetration hole of the cover 830 is placed on the upper part of the second storage groove 820. FIG. 8 illustrates such state.

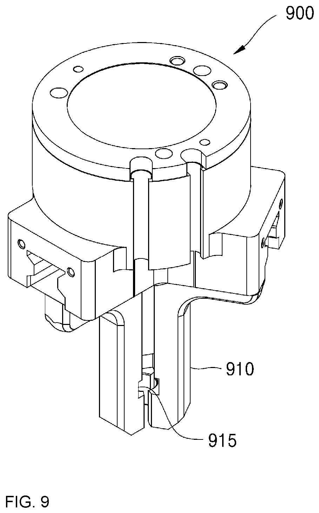

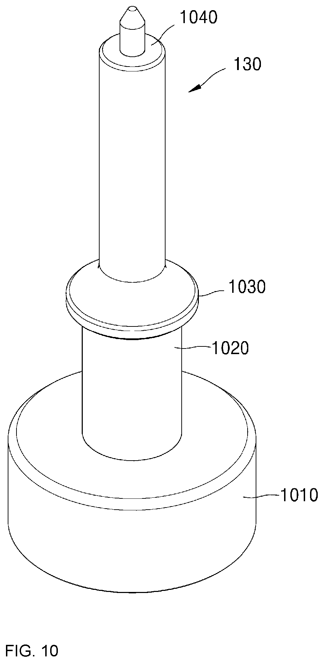

FIG. 9 illustrates a gripper 900 combined to the base body 310 of FIG. 3 and FIG. 10 illustrates the fixing pin 130 combined to the jig table 110 in the routing apparatus 100 of FIG. 1.

Referring to FIGS. 1 through 10, the fixing pin 130 may be combined to the upper surface of the jig table 110 to be detachable. The fixing pin 130 may be fixed to the upper surface of the jig table 110 by using a magnetic force. For example, the upper surface of the jig table 110 may have a magnetic force or the lower surface of the fixing pin 130 may have a magnetic force. The fixing pin 130 may include a lower body 1010 and an upper body 1020, wherein the bottom surface of the lower body 1010 contacts and is combined to the jig table 110, and the upper body 1020 having a cylindrical form is combined to the upper part of the lower body 1010. The upper body 1020 may include a projection 1030 formed along an outer circumference surface of the upper body 1020 at the upper part of a portion which is gripped by the gripper 900. Also, a stepped part 1040 may be formed at the upper part of the projection 1030 in the upper body 1020 so that the board 120 may be combined and fixed. That is, the board 120 is placed at the lower surface of the stepped part 1040 and the edge of the board 120 is fit in the side of the stepped part 1040 so that the board 120 may be fixed by using the fixing pin 130. Accordingly, the fixing pin 130 needs to be combined and fixed on the jig table 110 in accordance with a size of the board 120. However, since the size of the board 120 is not always uniform and thereby, the position where the fixing pin 130 is combined needs to be changed according to the size of the board 120, the fixing pin 130 may be fixed to a desired position on the jig table 110 by using the gripper 900.

The gripper 900 is combined to the base body 310 so as to move the base body 310 and thus, the gripper 900 may also move along with the base body 310. Accordingly, as described above, since the base body 310 is moved in a vertical direction or a horizontal direction, the board 120 may be cut or dust may be collected. Also, as will be described below, the base body 310 is moved in a vertical direction or a horizontal direction in order to fix the board 120 and then, the gripper 900 may be used to grip the fixing pin 130. The gripper 900 grips the fixing pin 130 placed in a pin storage unit 170 and moves the fixing pin 130 to the upper surface of the jig table 110. Also, the gripper 900 grips the fixing pin 130 combined to the upper surface of the jig table 110 and moves the fixing pin 130 to the pin storage unit 170. When the fixing pin 130 is combined to the jig table 110 by using a magnetic force, the gripper 900 may remove the fixing pin 130 from the jig table 110 by using power greater than the magnetic force used to combine the fixing pin 130 to the jig table 110. The gripper 900 includes a combination groove 915 at a part gripping the fixing pin 130 and the lower part of the combination groove 915 contacts the lower part of the projection 1030 in the upper body 1020 of the fixing pin 130. Since the combination groove 915 is combined to the projection 1030 of the fixing pin 130, the combination groove 915 may grip and move the fixing pin 130. The gripper 900 may strongly grip the fixing pin 130 in such a way that legs where the combination groove 915 is formed are folded out and folded back in all directions. Such a type of the gripper is called a finger type gripper and the gripper 900 of the present invention may be the finger type gripper. However, the present invention is not limited thereto and the gripper 900 may have other various forms if the gripper 900 may grip the fixing pin 130 and move the fixing pin 130 between the pin storage unit 170 and the jig table 110.

The routing apparatus according to an embodiment of the present invention collects dust while the first body surrounding the routing bit is combined to the base body and moves along with the routing bit to cut the bridge of the board. Accordingly, dispersion of dust while cutting the board may be minimized and dust collection is performed only in a limited section so that dust collection efficiency may be greatly increased. Also, In the routing apparatus according to an embodiment of the present invention, the first body may be easily removed in a section, where the board is not cut by the routing bit, and the second body is bonded to the base body. Accordingly, dust which is not absorbed by the first body and fell on the jig table may be collected. That is, according to the present invention, dust may be absorbed by the first body combined to surround the routing bit while the routing bit cuts the board, and dust which is not absorbed by the first body and fell on the jig table may be also absorbed by the second body combined instead of the first body. Therefore, dust may be completely removed compared with the conventional art. In addition, the routing apparatus according to an embodiment of the present invention may use the gripper to move the fixing pin used to fix the board or to easily remove the fixing pin from the jig table.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A routing apparatus (100) which is adapted to cut a bridge of a board (120) placed on a jig table (110) and to separate the board (120) into a unit board, the apparatus comprising:
a base body (310) comprising a routing bit (350) combined thereto in a downward direction in a first space (313) located within the base body (310), the routing bit (350) being adapted to move in horizontal and vertical directions, and to project further toward a downward direction than the lower end part of the base body (310) and thereby to contact the bridge to cut it;
a first body (410) comprising a second space (413), the first body being adapted to be combined to the base body (310) to connect the second space (413) to the first space (313) of the base body (310) by surrounding the routing bit (350) to form one continuous space so that the routing bit (350) is placed in the second space (413), and comprising a first brush (415) at the end part thereof toward the board, the first body (410) being adapted to be detached from the base body (310); and
an absorbing unit (330) adapted to absorb the first space (313) of the base body (310),
wherein in a first mode, where the routing bit (350) is adapted to cut the bridge, the first body (410) can be combined to the base body (310), the base body (310) is adapted to move in a vertical direction, and the absorbing unit (330) is adapted to absorb air and dust from the second space (413) of the first body (410) through the first space (313) of the base body (310) while the first brush (415) contacts the board (120),
**characterized in that** the routing apparatus (100) further comprises a second body (420) which comprises a third space (423), the second body (420) being adapted to be combined to the base body (310) to connect the first space (313) of the base body (310) to the third space (423) to form one continuous space, the second body (420) comprises a second brush (425) at the end part thereof toward the board, the second body (420) being adapted to be detached from the base body (310), wherein in a second mode, where dust of the jig table is to be removed, the first body (410) can be detached from the base body (310), the second body (420) can be combined to the base body (310), the base body (310) is adapted to move in a vertical direction, and the absorbing unit (330) is adapted to absorb air and dust from the third space (423) of the second body (420) through the first space (313) of the base body (310) while the second brush (425) contacts the jig table, and
wherein the second body (420) is longer than the first body (410) in a vertical direction and the end part of the second body (420) is projected further toward a downward direction than the end part of the routing bit (350), when the second body (420) is combined to the base body (310) instead of the first body (410).

2. The routing apparatus of claim 1, further comprising a storage unit (150) in which a first storage groove (810) adapted for storing the first body (410) and a second storage groove (820) adapted for storing the second body (420) are formed, wherein in the first mode, the base body (310) is adapted to move to the storage unit (150) and is combined to the first body (410) by using a magnetic force and in the second mode, the base body (310) is adapted to move to the storage unit (150) and is combined to the second body (420) by using a magnetic force.

3. The routing apparatus of claim 2, wherein the storage unit (150) comprises:
a cover (830) for opening the whole or a part of the upper part of the first storage groove (810) or opening the whole or a part of the upper part of the second storage groove (820), the cover being adapted to move in a horizontal direction on the upper part of the storage unit (150); and
a cover operating unit (835) adapted to move the cover (830) in a horizontal direction,
wherein when the base body (310) is to be combined to the first body (410), the cover operating unit (835) is configured to move the cover (930) to open the whole of the upper part of the first storage groove (810), and when the first body (410) combined to the base body (310) is to be separated, the cover operating unit (835) is adapted to move the cover (830) to partially open the upper part of the first storage groove (810) while the first body (410) is moved to the first storage groove (810), and wherein when the base body (310) is to be combined to the second body (420), the cover operating unit (835) is adapted to move the cover (830) to open the whole of the upper part of the second storage groove (820), and when the second body (420) combined to the base body (310) is to be separated, the cover operating unit (835) is adapted to move the cover (830) to partially open the upper part of the second storage groove (820) while the second body (420) is moved to the second storage groove (820).

4. The routing apparatus of claim 1, further comprising:
a plurality of fixing pins (130) combined to be detachable on the upper surface of the jig table; and
a gripper (900) combined to the base body (310) for moving the fixing pins (130) to the upper surface of the jig table from a pin storage unit (170) or moving the fixing pins (130) combined to the upper surface of the jig table to the pin storage unit (170),
wherein the fixing pins (170) combined to the jig table are adapted to fix the board.

5. The routing apparatus of claim 4, wherein a fixing pin (130) is adapted to be fixed on the jig table by using a magnetic force and the gripper (900) is adapted to remove the fixing pin (130) from the jig table by using power greater than the magnetic force used to combine the fixing pin (130) to the jig table.

6. The routing apparatus of claim 4, wherein a fixing pin (130) comprises:
a lower body (1010) in which the bottom surface thereof is adapted to contact and to combine to the jig table; and
an upper body (1020) having a cylindrical form combined to the upper part of the lower body (1010), comprising a projection formed along an outer circumference surface thereof, and comprising a stepped part, where the board is suitable to be combined and fixed, at the upper part of the projection,
wherein the gripper (900) comprises a combination groove (915) at a part gripping the fixing pin (130), the lower part of the combination groove (915) is adapted to contact the lower part of the projection in the upper body (1020), and the combination groove (915) is adapted to grip and move the fixing pin (130) since the projection of the fixing pin (130) is combined to the combination groove (915).

7. The routing apparatus of claim 4, wherein the gripper (900) is a finger type gripper.

## Patentansprüche

1. Fräsvorrichtung (100), die dazu ausgelegt ist, eine Brücke einer auf einem Vorrichtungstisch (110) platzierten Platte (120) zu durchtrennen und die Platte (120) in eine Einzelplatte zu separieren, wobei die Vorrichtung umfasst:
einen Grundkörper (310), der einen Fräser (350) umfasst, der in einem ersten Raum (313), der innerhalb des Grundkörpers (310) angeordnet ist, in Abwärtsrichtung mit diesem kombiniert ist, wobei der Fräser (350) dazu ausgelegt ist, sich in horizontaler und vertikaler Richtung zu bewegen und weiter in Abwärtsrichtung vorzustehen als das untere Endteil des Grundkörpers (310) und dadurch die Brücke zu kontaktieren, um diese zu durchtrennen;
einen ersten Körper (410), der einen zweiten Raum (413) umfasst, wobei der erste Körper dazu ausgelegt ist, mit dem Grundkörper (310) kombiniert zu werden, um den zweiten Raum (413) mit dem ersten Raum (313) des Grundkörpers (310) zu verbinden, indem der Fräser (350) umschlossen wird, um einen durchgehenden Raum zu bilden, so dass der Fräser (350) in dem zweiten Raum (413) platziert ist, und der an seinem zur Platte hin gerichteten Endteil eine erste Bürste (415) umfasst, wobei der erste Körper (410) dazu ausgelegt ist, von dem Grundkörper (310) abgenommen zu werden; und
eine Absorptionseinheit (330), die dazu ausgebildet ist, den ersten Raum (313) des Grundkörpers (310) zu absorbieren,
wobei in einem ersten Modus, in dem der Fräser (350) dazu ausgelegt ist, die Brücke zu durchtrennen, der erste Körper (410) mit dem Grundkörper (310) kombiniert sein kann, der Grundkörper (310) so ausgelegt ist, dass er sich in vertikaler Richtung bewegt, und die Absorptionseinheit (330) so ausgelegt ist, dass sie Luft und Staub aus dem zweiten Raum (413) des ersten Körpers (410) durch den ersten Raum (313) des Grundkörpers (310) absorbiert, während die erste Bürste (415) die Platte (120) kontaktiert,
**dadurch gekennzeichnet, dass** die Fräsvorrichtung (100) ferner einen zweiten Körper (420) umfasst, der einen dritten Raum (423) umfasst, wobei der zweite Körper (420) so ausgelegt ist, dass er mit dem Grundkörper (310) kombiniert werden kann, um den ersten Raum (313) des Grundkörpers (310) mit dem dritten Raum (423) zu verbinden, um einen kontinuierlichen Raum zu bilden, wobei der zweite Körper (420) eine zweite Bürste (425) an seinem Endteil in Richtung der Platte umfasst, wobei der zweite Körper (420) dazu ausgelegt ist, von dem Grundkörper (310) abgenommen zu werden, wobei in einem zweiten Modus, in dem Staub von dem Vorrichtungstisch entfernt werden soll, der erste Körper (410) von dem Grundkörper (310) abgenommen werden kann, der zweite Körper (420) mit dem Grundkörper (310) kombiniert werden kann, der Grundkörper (310) so ausgelegt ist, dass er sich in vertikaler Richtung bewegen kann, und die Absorptionseinheit (330) so ausgelegt ist, dass sie Luft und Staub aus dem dritten Raum (423) des zweiten Körpers (420) durch den ersten Raum (313) des Grundkörpers (310) absorbiert, während die zweite Bürste (425) den Vorrichtungstisch berührt, und
wobei der zweite Körper (420) in vertikaler Richtung länger ist als der erste Körper (410) und das Endteil des zweiten Körpers (420) weiter in Abwärtsrichtung vorsteht als das Endteil des Fräsers (350), wenn der zweite Körper (420) anstelle des ersten Körpers (410) mit dem Grundkörper (310) kombiniert ist.

2. Fräsvorrichtung nach Anspruch 1, ferner umfassend eine Aufbewahrungseinheit (150), in der eine erste Aufbewahrungsnut (810), die zum Aufbewahren des ersten Körpers (410) ausgelegt ist, und eine zweite Aufbewahrungsnut (820), die zum Aufbewahren des zweiten Körpers (420) ausgelegt ist, ausgebildet sind, wobei im ersten Modus der Grundkörper (310) dazu ausgelegt ist, sich zur Aufbewahrungseinheit (150) zu bewegen, und unter Verwendung einer Magnetkraft mit dem ersten Körper (410) kombiniert ist, und im zweiten Modus der Grundkörper (310) dazu ausgelegt ist, sich zur Aufbewahrungseinheit (150) zu bewegen, und unter Verwendung einer Magnetkraft mit dem zweiten Körper kombiniert ist.

3. Fräsvorrichtung nach Anspruch 2, wobei die Aufbewahrungseinheit (150) umfasst:
eine Abdeckung (830) zum Öffnen des gesamten oder eines Teils des oberen Teils der ersten Aufbewahrungsnut (810) oder zum Öffnen des gesamten oder eines Teils des oberen Teils der zweiten Aufbewahrungsnut (820), wobei die Abdeckung dazu ausgelegt ist, sich in horizontaler Richtung auf dem oberen Teil der Aufbewahrungseinheit (150) zu bewegen; und
eine Abdeckungsbetätigungseinheit (835), die dazu ausgelegt ist, die Abdeckung (830) in horizontaler Richtung zu bewegen,
wobei, wenn der Grundkörper (310) mit dem ersten Körper (410) kombiniert werden soll, die Abdeckungsbetätigungseinheit (835) dazu konfiguriert ist, die Abdeckung (930) zu bewegen, um den gesamten oberen Teil der ersten Aufbewahrungsnut (810) zu öffnen, und wenn der mit dem Grundkörper (310) kombinierte erste Körper (410) separiert werden soll, die Abdeckungsbetätigungseinheit (835) dazu ausgelegt ist, die Abdeckung zu bewegen, um den oberen Teil der ersten Aufbewahrungsnut (810) teilweise zu öffnen, während der erste Körper (410) zur ersten Aufbewahrungsnut (810) bewegt wird, und wobei, wenn der Grundkörper (310) mit dem zweiten Körper (420) kombiniert werden soll, die Abdeckungsbetätigungseinheit (835) dazu ausgelegt ist, die Abdeckung (830) zu bewegen, um den gesamten oberen Teil der zweiten Aufbewahrungsnut (820) zu öffnen, und wenn der mit dem Grundkörper (310) kombinierte zweite Körper (420) separiert werden soll, ist die Abdeckungsbetätigungseinheit (835) dazu ausgelegt, die Abdeckung (830) zu bewegen, um den oberen Teil der zweiten Aufbewahrungsnut (820) teilweise zu öffnen, während der zweite Körper (420) zur zweiten Aufbewahrungsnut (820) bewegt wird.

4. Fräsvorrichtung (100) nach Anspruch 1, ferner umfassend:
eine Vielzahl von Befestigungsstiften (130), die so kombiniert sind, dass sie auf der oberen Oberfläche des Vorrichtungstisches (110) abnehmbar sind; und
einen Greifer (900), der mit dem Grundkörper (310) kombiniert ist, um die Befestigungsstifte (130) aus einer Stift-Aufbewahrungseinheit (170) zu der oberen Oberfläche des Vorrichtungstisches (110) zu bewegen oder die mit der oberen Oberfläche des Vorrichtungstisches (110) kombinierten Befestigungsstifte (130) zur Stift-Aufbewahrungseinheit (170) zu bewegen,
wobei die mit dem Vorrichtungstisch kombinierten Befestigungsstifte (170) dazu ausgelegt sind, die Platte zu befestigen.

5. Fräsvorrichtung nach Anspruch 4, wobei ein Befestigungsstift (130) dazu ausgelegt ist, unter Verwendung einer Magnetkraft auf dem Vorrichtungstisch befestigt zu werden, und der Greifer (900) dazu ausgelegt ist, den Befestigungsstift (130) unter Verwendung einer Kraft, die größer ist als die Magnetkraft, die zum Kombinieren des Befestigungsstifts (130) mit dem Vorrichtungstisch verwendet wird, von dem Vorrichtungstisch zu entfernen.

6. Fräsvorrichtung (100) nach Anspruch 4, wobei ein Befestigungsstift (130) umfasst:
einen unteren Körper (1010), dessen Unterseite dazu ausgelegt ist, den Vorrichtungstisch (110) zu kontaktieren und mit diesem kombiniert zu werden; und
einen oberen Körper (1020), der eine zylindrische Form aufweist, der mit dem oberen Teil des unteren Körpers (1010) kombiniert ist, einen entlang seiner Außenumfangsoberfläche gebildeten Vorsprung umfasst und einen abgestuften Teil umfasst, wobei die Platte dazu geeignet ist, an dem oberen Teil des Vorsprungs kombiniert und befestigt zu sein,
wobei der Greifer (900) eine Kombinationsnut (915) an einem Teil umfasst, der den Befestigungsstift (130) greift, der untere Teil der Kombinationsnut (915) dazu ausgelegt ist, den unteren Teil des Vorsprungs in dem oberen Körper (1020) zu kontaktieren, und die Kombinationsnut (915) dazu ausgelegt ist, den Befestigungsstift (130) zu greifen und zu bewegen, da der Vorsprung des Befestigungsstifts (130) mit der Kombinationsnut (915) kombiniert ist.

7. Fräsvorrichtung (100) nach Anspruch 4, wobei der Greifer (900) ein fingerartiger Greifer ist.

## Revendications

1. Appareil de fraisage (100) adapté pour couper une attache d'une carte (120) placée sur une table de gabarit (110) et pour séparer la carte (120) en une carte unitaire, l'appareil comprenant :
un corps de base (310) comprenant une fraise (350) associée à celui-ci vers le bas dans un premier espace (313) situé à l'intérieur du corps de base (310), la fraise routage (350) étant apte à se déplacer dans des directions horizontale et verticale, et à faire saillie davantage vers le bas que la partie d'extrémité inférieure du corps de base (310) et ainsi à entrer en contact avec l'attache pour la couper ;
un premier corps (410) comprenant un deuxième espace (413), le premier corps étant apte à être associé au corps de base (310) pour relier le deuxième espace (413) au premier espace (313) du corps de base (310) en entourant la fraise (350) afin de former un espace continu unique de sorte que la fraise (350) est placée dans le deuxième espace (413), et comprenant une première brosse (415) à son extrémité tournée vers la carte, le premier corps (410) étant apte à être détaché du corps de base (310) ; et
une unité d'aspiration (330) apte à aspirer dans le premier espace (313) du corps de base (310),
dans lequel, dans un premier mode, où la fraise (350) est apte à couper l'attache, le premier corps (410) peut être associé au corps de base (310), le corps de base (310) est apte à se déplacer dans une direction verticale, et l'unité d'aspiration (330) est apte à aspirer l'air et la poussière depuis le deuxième espace (413) du premier corps (410) à travers le premier espace (313) du corps de base (310) tandis que la première brosse (415) est en contact avec la carte (120),
**caractérisé en ce que** l'appareil de fraisage (100) comprend en outre un deuxième corps (420) qui comprend un troisième espace (423), le deuxième corps (420) étant apte à être associé au corps de base (310) pour relier le premier espace (313) du corps de base (310) au troisième espace (423) afin de former un espace continu unique, le deuxième corps (420) comprenant une deuxième brosse (425) à son extrémité tournée vers la carte, le deuxième corps (420) étant apte à être détaché du corps de base (310),
dans lequel, dans un deuxième mode, où de la poussière de la table de gabarit doit être retirée, le premier corps (410) peut être détaché du corps de base (310), le deuxième corps (420) peut être associé au corps de base (310), le corps de base (310) est apte à se déplacer dans une direction verticale, et l'unité d'aspiration (330) est apte à aspirer l'air et la poussière depuis le troisième espace (423) du deuxième corps (420) à travers le premier espace (313) du corps de base (310) tandis que la deuxième brosse (425) est en contact avec la table de gabarit, et
dans lequel le deuxième corps (420) est plus long que le premier corps (410) dans la direction verticale et l'extrémité du deuxième corps (420) fait saillie davantage vers le bas que l'extrémité de la fraise (350), lorsque le deuxième corps (420) est associé au corps de base (310) à la place du premier corps (410).

2. Appareil de fraisage selon la revendication 1, comprenant en outre une unité de stockage (150) dans laquelle une première rainure de stockage (810) apte à stocker le premier corps (410) et une deuxième rainure de stockage (820) apte à stocker le deuxième corps (420) sont formées, dans lequel, dans le premier mode, le corps de base (310) est apte à se déplacer vers l'unité de stockage (150) et est associé au premier corps (410) au moyen d'une force magnétique et, dans le deuxième mode, le corps de base (310) est apte à se déplacer vers l'unité de stockage (150) et est associé au deuxième corps (420) au moyen d'une force magnétique.

3. Appareil de fraisage selon la revendication 2, dans lequel l'unité de stockage (150) comprend :
un couvercle (830) destiné à ouvrir la totalité ou une partie de la partie supérieure de la première rainure de stockage (810) ou à ouvrir la totalité ou une partie de la partie supérieure de la deuxième rainure de stockage (820), le couvercle étant apte à se déplacer dans une direction horizontale sur la partie supérieure de l'unité de stockage (150) ; et
une unité de commande de couvercle (835) apte à déplacer le couvercle (830) dans une direction horizontale,
dans lequel, lorsque le corps de base (310) doit être associé au premier corps (410), l'unité de commande de couvercle (835) est configurée pour déplacer le couvercle (930) afin d'ouvrir la totalité de la partie supérieure de la première rainure de stockage (810), et lorsque le premier corps (410) associé au corps de base (310) doit être séparé, l'unité de commande de couvercle (835) est apte à déplacer le couvercle (830) afin d'ouvrir partiellement la partie supérieure de la première rainure de stockage (810) tandis que le premier corps (410) est déplacé vers la première rainure de stockage (810), et dans lequel, lorsque le corps de base (310) doit être associé au deuxième corps (420), l'unité de commande de couvercle (835) est apte à déplacer le couvercle (830) afin d'ouvrir la totalité de la partie supérieure de la deuxième rainure de stockage (820), et lorsque le deuxième corps (420) associé au corps de base (310) doit être séparé, l'unité de commande de couvercle (835) est apte à déplacer le couvercle (830) afin d'ouvrir partiellement la partie supérieure de la deuxième rainure de stockage (820) tandis que le deuxième corps (420) est déplacé vers la deuxième rainure de stockage (820).

4. Appareil de fraisage selon la revendication 1, comprenant en outre :
une pluralité de broches de fixation (130) associées de manière détachable sur la surface supérieure de la table de gabarit ; et
un préenseur (900) associé au corps de base (310) pour déplacer les broches de fixation (130) vers la surface supérieure de la table de gabarit depuis une unité de stockage de broches (170) ou pour déplacer les broches de fixation (130) associées sur la surface supérieure de la table de gabarit vers l'unité de stockage de broches (170),
dans lequel les broches de fixation (170) associées à la table de gabarit sont aptes à fixer la carte.

5. Appareil de fraisage selon la revendication 4, dans lequel une broche de fixation (130) est apte à être fixée sur la table de gabarit au moyen d'une force magnétique et le préenseur (900) est apte à retirer la broche de fixation (130) de la table de gabarit au moyen d'une force supérieure à la force magnétique utilisée pour associer la broche de fixation (130) à la table de gabarit.

6. Appareil de fraisage selon la revendication 4, dans lequel une broche de fixation (130) comprend :
un corps inférieur (1010) dont la surface inférieure est apte à entrer en contact avec la table de gabarit et à être associée à celle-ci ; et
un corps supérieur (1020) ayant une forme cylindrique associé à la partie supérieure du corps inférieur (1010), comprenant une saillie formée le long d'une surface de circonférence extérieure de celui-ci, et comprenant une partie en gradin, où la carte est apte à être associée et fixée, au niveau de la partie supérieure de la saillie,
dans lequel le préenseur (900) comprend une rainure d'association (915) au niveau d'une partie saisissant la broche de fixation (130), la partie inférieure de la rainure d'association (915) est apte à entrer en contact avec la partie inférieure de la saillie dans le corps supérieur (1020), et la rainure d'association (915) est apte à saisir et à déplacer la broche de fixation (130) puisque la saillie de la broche de fixation (130) est associée à la rainure d'association (915).

7. Appareil de fraisage selon la revendication 4, dans lequel le préenseur (900) est un préenseur de type à doigts.
